## Europäisches Patentamt

## European Patent Office

## Office européen des brevets

(19)

(11) Veröffentlichungsnummer: **0 193 995**
**B1**

(12) # EUROPÄISCHE PATENTSCHRIFT

(45) Veröffentlichungstag der Patentschrift:
27.12.89

(51) Int. Cl.⁴: **H 03 J 5/24**

(21) Anmeldenummer: **86200322.5**

(22) Anmeldetag: **03.03.86**

(54) Schaltungsanordnung für einen Tuner zur Umschaltung mehrerer Frequenzbereiche.

(30) Priorität: **06.03.85 DE 3507865**

(43) Veröffentlichungstag der Anmeldung:
**10.09.86 Patentblatt 86/37**

(45) Bekanntmachung des Hinweises auf die Patenterteilung:
27.12.89 Patentblatt 89/52

(84) Benannte Vertragsstaaten:
**DE FR GB IT**

(56) Entgegenhaltungen:
DE-A-2 045 821
FR-A-1 403 806
GB-A-2 025 178

(73) Patentinhaber: **Philips Patentverwaltung GmbH, Wendenstrasse 35 Postfach 10 51 49, D-2000 Hamburg 1 (DE)**

(84) Benannte Vertragsstaaten: **DE**

(73) Patentinhaber: **N.V. Philips' Gloeilampenfabrieken, Groenewoudseweg 1, NL- 5621 BA Eindhoven (NL)**

(84) Benannte Vertragsstaaten: **FR GB IT**

(72) Erfinder: **Kupfer, Karl- Heinz, Krefelder Strasse 145, D-4150 Krefeld 29 (DE)**

(74) Vertreter: **Kupfermann, Fritz- Joachim, Dipl.- Ing., Philips Patentverwaltung GmbH Wendenstrasse 35 Postfach 10 51 49, D-2000 Hamburg 1 (DE)**

LIBER, STOCKHOLM 1989

**Beschreibung**

Die Erfindung betrifft eine Schaltungsanordnung für einen Tuner, insbesondere Fernsehtuner, zur Umschaltung mehrerer durch Bandpässe ausgefilterter Frequenzbereiche, insbesondere der Frequenzbereiche Hyperband und UHF-Band, mittels Dioden, die auch als Mischdioden zur ZF-Mischung dienen und die auf einen gemeinsamen ZF-Kreis arbeiten.

Bei solchen Schaltungsanordnungen ist es bekannt, jedem der Frequenzbereiche einen ZF-Oszillator und eine ZF-Mischdiode zuzuordnen. Hinter jeder HF-Mischdiode ist ein ZF-Kreis angeordnet, der auf einen Eingang eines ZF-Verstärkers führt. Es sind also z. B. für Hyperband und UHF-Band zwei Eingänge eines HF-Verstärker-ICs erforderlich. Die Umschaltung zwischen Hyperband und UHF-Band wird dadurch vorgenommen, daß in jedem der beiden Frequenzbereiche hinter dem ZF-Kreis eine Schaltungsanordnung mit einer Schaltdiode vorgesehen ist, die mit Hilfe einer von außen zuzuführenden Gleichspannung geschaltet wird. Auf diese Weise kann eine Umschaltung zwischen den Frequenzbereichen vorgenommen werden.

Ferner ist aus der DE-A-2 927 225 eine Schaltung zum Mischen und Frequenzband-Umschalten für ein MehrbandAbstimmsystem bekannt, bei der für jeden Frequenzbereich eine Mischdiode vorgesehen ist, die sowohl die ZF-Mischfunktion wie auch eine Umschaltung der Frequenzbereiche vornimmt. Die Einschaltung des gewünschten Frequenzbereichs wird mittels GleichspannungsSchaltsignalen vorgenommen, wodurch die sonst gesperrte Mischdiode leitend wird. Die Gleichspannungen werden über Widerstandsnetzwerke eingespeist; ferner müssen die Gleichspannungen in der Schaltung wieder abgetrennt werden, damit sie keine Störungen verursachen.

Aus der DE-A-2 045 821 ist ein Rundfunkempfänger für amplituden- und frequenzmodulierte Signale bekannt, der einen einzigen Frequenzmischkreis aufweist. Diesem werden an seinem Eingang die empfangenen Signale sowohl des AM-als auch des FM-Frequenzbands zugeleitet sowie unmittelbar oder über einen FM-Abstimmkreis die Schwingungen von wahlweise einem FM-Empfangsoszillatorkreis bzw. einem AM-Oszillatorkreis. Bei dieser Anordnung ist der Frequenzmischkreis stets wirksam, während die Empfangsoszillatorkreise durch als Schiebeschalter ausgebildete Einrichtungen ein- bzw. ausgeschaltet werden können. Durch diese Einrichtungen wird der Betrieb des Frequenzmischkreises nicht beeinflußt.

Es ist Aufgabe der Erfindung, eine Schaltungsanordnung der eingangs genannten Art zur Umschaltung mehrerer Frequenzbereiche und zur ZF-Mischung zu vereinfachen und damit die Fertigung wirtschaftlicher zu machen.

Diese Aufgabe ist erfindungsgemäß dadurch gelöst, daß die Schaltungsanordnung für jeder der Frequenzbereiche einen ein- und ausschaltbaren HF-Oszillator aufweist und daß die Einschaltung des gewünschten Frequenzbereiches durch Einschalten des ihm zugeordneten HF-Oszillators vorgenommen wird, wodurch die sonst gesperrte Mischdiode dieses Frequenzbereiches leitend wird.

Eine solche Schaltungsanordnung weist also für jeden Frequenzbereich eine Mischdiode auf, die gleichzeitig auch Schaltfunktion hat. Hinter den Dioden ist ein gemeinsamer ZF-Kreis angeordnet, dessen Ausgang z. B. zu einem Eingang eines ZF-Verstärker-ICs führt. In dieser Schaltungsanordnung werden keine Gleichspannungen mehr benötigt, um die Schalt- bzw. Mischdioden entsprechend vorzuspannen. Infolgedessen werden weder Widerstands-Netzwerke zu deren Einspeisung noch Maßnahmen zu deren Abtrennung erforderlich. Zur Umschaltung der Frequenzbereiche werden statt dessen die den verschiedenen Frequenzbereichen zugeordneten HF-Oszillatoren schaltbar ausgeführt. Zur Einschaltung eines Frequenzbereiches wird lediglich der diesem Frequenzbereich zugeordnete HF-Oszillator eingeschaltet, so daß die dem Frequenzbereich zugeordnete Mischdiode während der positiven Halbwellen des an ihr anliegenden Signals leitend wird. Der HF-Oszillator des oder der anderen Frequenzbereiche ist ausgeschaltet, so daß die diesem bzw. diesen Frequenzbereich(en) zugeordneten Schaltdioden dauernd gesperrt sind. Auf diese Weise kann trotz einfachen und wirtschaftlichen Aufbaus eine Umschaltung der Frequenzbereiche ohne technische Nachteile vorgenommen werden.

Ein Ausführungsbeispiel der Erfindung wird anhand der Zeichnungen näher erläutert. Es zeigen:

Fig. 1 das Blockschaltbild einer Schaltungsanordnung zur Umschaltung und Mischung der Frequenzbereiche Hyperband und UHF-Band,

Fig. 2 ein Schaltbild eines Ausführungsbeispiels für eine Schaltungsanordnung zur Umschaltung und Mischung der Frequenzbereiche Hyperband und UHF-Band nach Fig. 1.

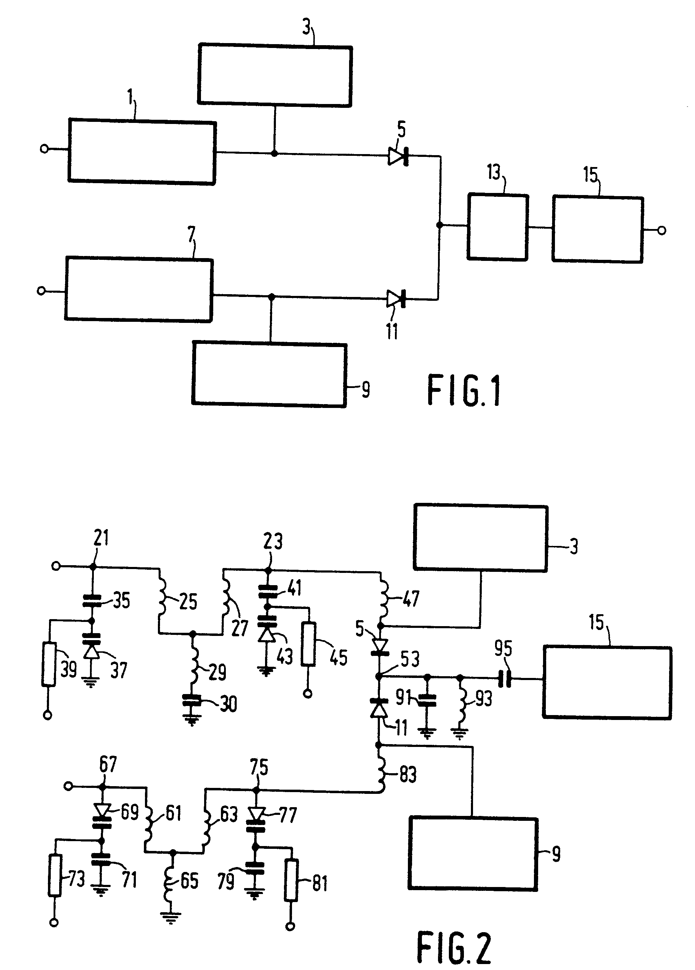

Das Blockschaltbild in Fig. 1 zeigt ein Bandfilter für Hyperband 1 und einen schaltbaren HF-Oszillator für das Hyperband 3, deren Ausgänge auf die Anode einer Mischdiode 5 führen. Im UHF-Bereich sind das entsprechende Bandfilter 7, der schaltbare HF-Oszillator 9 und die Mischdiode 11 in gleiche Weise verschaltet. Die Kathoden der Mischdioden 5 und 11 führen auf einen gemeinsamen ZF-Kreis 13, dessen Ausgang auf den Eingang eines ZF-Verstärkers 15 führt, z. B. einen ZF-Verstärker-IC.

Das Schaltbild in Fig. 2 zeigt oben ein bekanntes Bandfilter für den Frequenzbereich Hyperband. Zwischen dem Eingang 21 und dem Ausgang 23 des Bandfilters sind die Induktivitäten 25 und 27 in Reihe und vom Verbindungspunkt zwischen diesen beiden Induktivitäten die

3

Induktivität 29 und die Kapazität 30 in Reihe gegen Masse geschaltet. Die Abstimmung dieses Bandfilters wird vorgenommen durch jeweils am Ein- und am Ausgang angeordnete Kapazitätsdioden 37, 43. Am Eingang ist dazu über den Kondensator 35 die Kapazitätsdiode 37 mit ihrer Anode gegen Masse geschaltet. Die Abstimmspannung wird über einen Widerstand 39 der Kathode der Diode 37 zugeführt. Am Ausgang des Bandfilters sind in gleicher Weise verschaltet ein Kondensator 41, die Kapazitätsdiode 43 und ein Widerstand 45. Das Signal am Ausgang 23 des Hyperbandfilters gelangt über eine Ankoppelspule 47 zur Anode einer Mischdiode 5. Ebenfalls mit der Anode der Mischdiode 5 verbunden ist der Ausgang eines nicht näher dargestellten HF-Oszillators 3 für das Hyperband, der schaltbar ausgeführt ist. Die Kathode der Mischdiode 5 führt zu einem Sternpunkt 53. Das UHF-Bandfilter, bestehend aus den Induktivitäten 61, 63 und 65, ist entsprechend dem Hyperbandfilter aufgebaut, jedoch ohne Kapazität. Eine Abstimmeinheit am Eingang 67 des UHF-Bandfilters weist eine Kapazitätsdiode 69 auf, deren Kathode mit dem Eingang 67 des Bandfilters und deren Kathode über eine Kapazität 71 mit Masse verbunden ist. Die Abstimmspannung wird über einen Widerstand 73 zur Kathode der Kapazitätsdiode 69 geführt. Der Ausgang 75 des UHF-Bandfilters weist eine zweite Abstimmeinheit auf, in der eine Kapazitätsdiode 77, eine Kapazität 79 und ein Widerstand 81 in gleicher Weise wie in der Abstimmeinheit am Eingang des UHF-Filters verschaltet sind. Der Ausgang 75 des UHF-Bandfilters führt über eine Ankoppelspule 83 zur Kathode einer Mischdiode 11, die, analog dem Hyperbandteil, mit dem Ausgang eines UHF-HF-Oszillators 9 verbunden ist. Die Kathode der Mischdiode 11 führt, ebenso wie die der Mischdiode 5 des Hyperbandteils, auf den Sternpunkt 53. Der Sternpunkt 53 ist ferner verbunden mit einem ZF-Kreis, der eine gegen Masse geschaltete Kapazität 91 und eine ebenfalls gegen Masse geschaltete Induktivität 93 aufweist. Der Sternpunkt 53 führt über eine Kapazität 95 zu einem nachfolgenden ZF-Verstärker 15, der z. B. ein ZF-Verstärker-IC sein kann.

Die Wirkungsweise dieser Schaltung ist folgende: Die Sperrspannung der Mischdioden 5 bzw. 11 wird, wenn der jeweils vorgeschaltete HF-Oszillators 3 bzw. 9 ausgeschaltet ist, nicht überschritten, d. h. die Mischdioden sind gesperrt und schalten das jeweilige Frequenzband nicht zum Sternpunkt 53 und damit zum ZF-Kreis durch. Ein Durchschalten der jeweiligen Mischdiode 5 bzw. 11 geschieht erst, wenn der jeweilige Oszillator 8 bzw. 9 eingeschaltet ist und damit die Schaltspannung der Diode 5 bzw. 11 überschritten wird. Die Kapazität 91 des ZF-Kreises hat außerdem die Aufgabe, durch nicht dargestellte Primärbandfilter evtl. nicht ausgefilterte höhere Frequenzen nach Masse abzublocken und somit sicherzustellen, daß die Mischdioden 5 bzw. 11 sperren, wenn der jeweils vorgeschaltete HF-Oszillator 3 bzw. 9 nicht eingeschaltet ist.

4

Die Umschaltung zwischen den Frequenzbändern Hyperband und UHF-Band wird in der Schaltungsanordnung also mit Hilfe der Dioden 5 und 11, die sowohl Misch- wie auch Schaltfunktion haben, durch das Einschalten des dem jeweiligen Frequenzbereich zugeordneten HF-Oszillators 3 bzw. 9 vorgenommen.

## Patentansprüche

Schaltungsanordnung für einen Tuner, insbesondere Fernsehtuner, zur Umschaltung mehrerer durch Bandpässe (1, 7) ausgefilterter Frequenzbereiche, insbesondere der Frequenzbereiche Hyperband und UHF-Band, mittels Dioden (5, 11), die auch als Mischdioden zur ZF-Mischung dienen und die auf einen gemeinsamen ZF-Kreis arbeiten, *dadurch gekennzeichnet*, daß die Schaltungsanordnung für jeden der Frequenzbereiche einen ein- und ausschaltbaren HF-Oszillator (3, 9) aufweist und daß die Einschaltung des gewünschten Frequenzbereiches durch Einschalten des ihm zugeordneten HF-Oszillators (3, 9) vorgenommen wird, wodurch die sonst gesperrte Mischdiode (5, 11) dieses Frequenzbereiches leitend wird.

## Claims

A circuit arrangement for a tuner, particularly a television tuner, for changing over several frequency ranges filtered out by bandpass filters (1, 7), particularly the hyperband and UHF band frequency ranges, by means of diodes (5, 11) which also serve as mixer diodes for IF mixing and which are connected to a common IF-circuit, *characterized* in that the circuit arrangement comprises an RF oscillator (3, 9) which can be switched on and off for each of the frequency ranges and in that the desired frequency range is switched on by switching on its associated RF oscillator (3, 9) so that the otherwise cut-off mixer diode (5, 11) of said frequency range becomes conducting.

## Revendications

Montage de circuit pour un tuner, en particulier un tuner TV, pour la commutation de plusieurs gammes de fréquences filtrées par des filtres passebande (1, 7), en particulier des gammes de fréquences en bande hyper et bande UHF, au moyen de diodes (5, 11) qui servent aussi de diodes mélangeuses pour le mélange MF et qui opèrent sur un circuit MF commun, *caractérisé* en ce que le montage de circuit comporte, pour chacune des gammes de fréquences, un oscillateur HF pouvant être enclenché et déclenché (3, 9) et que l'enclenchement de la gamme de fréquences souhaitée est effectué par enclenchement de l'oscillateur HF (3, 9) qui y est associé, grâce à quoi la diode mélangeuse (5, 11) de cette gamme de fréquences qui sinon est bloquée devient conductrice.

FIG.1

FIG.2